Europäisches Patentamt

European Patent Office

Office européen des brevets

(19)

(11) Veröffentlichungsnummer : **0 070 533**
**B1**

(12) **EUROPÄISCHE PATENTSCHRIFT**

(45) Veröffentlichungstag der Patentschrift :
23.12.87

(51) Int. Cl.⁴ : **H 01 L 23/52**

(21) Anmeldenummer : 82106401.1

(22) Anmeldetag : 16.07.82

(54) **Substrat für Halbleiterchips.**

(30) Priorität : 22.07.81 US 285725

(43) Veröffentlichungstag der Anmeldung :
26.01.83 Patentblatt 83/04

(45) Bekanntmachung des Hinweises auf die Patenterteilung : 23.12.87 Patentblatt 87/52

(84) Benannte Vertragsstaaten :
DE FR GB IT

(56) Entgegenhaltungen :
EP-A- 0 006 444
FR-A- 1 540 051
FR-A- 2 461 361
US-A- 3 370 203
IBM TECHNICAL DISCLOSURE BULLETIN, Band 22,
Nr. 5, Oktober 1979, Seiten 1841-1842, New York, US;
A.H. JOHNSON u.a.: "Multilayer ceramic fixed layer
substrate design"

(73) Patentinhaber : **International Business Machines Corporation**
**Old Orchard Road**
**Armonk, N.Y. 10504 (US)**

(72) Erfinder : **Dougherty, William Edwin, Jr.**
**34 La Grange Avenue**
**Poughkeepsie New York 12603 (US)**
Erfinder : **Greer, Stuart Eugene**
**R.R. 1, Box 299A**
**Shelburne Vermont 05482 (US)**
Erfinder : **Nestork, William John**
**RD. No. 1, Box 120**
**Hinesburg Vermont 05461 (US)**
Erfinder : **Norris, William Tilden**
**109 Spanish Oak Circle**
**Georgetown Texas 78626 (US)**

(74) Vertreter : **Neuland, Johannes, Dipl.-Ing.**
**IBM Deutschland GmbH Schönaicher Strasse 220**
**D-7030 Böblingen (DE)**

## Beschreibung

Die Erfindung bezieht sich auf ein Substrat für Halbleiterchips das mit einem sich wiederholenden Muster von Leiterzugsenden versehen ist, wobei jedes Muster Stellen markiert, um das Aufnehmen einer Vielfalt verschiedener Halbleiterchips zu erlauben. Die Leiterzugsenden sind so verdrahtet, daß sie sowohl innerhalb des selben Musters Verbindungen herstellen als auch mit benachbarten Mustern. Dies erlaubt das Personalisieren eines gemeinsamen Substrates, das viele verschiedene Kombinationen von Halbleiterchips aufnimmt.

Bei der Entwicklung der Halbleitertechnologie hat das Packen der Halbleiterchips eine zunehmende Wichtigkeit angenommen. Die Anzahl der Schaltungen, die auf einem Halbleiterchip untergebracht werden können, hat dramatisch zugenommen wie auch die Anzahl der Funktionen auf einem Halbleiterchip. Es gibt Halbleiterchips, die in der Hauptsache Speicher sind, solche die in erster Linie logische Schaltungen enthalten und solche, auf denen logische Schaltungen und Speicher gemischt sind. Mit dem Fortschreiten der Miniaturisierung wird es zunehmend wünschenswerter, eine Reihe von verschiedenen Halbleiterchips und verschiedene Kombinationen von Halbleiterchips auf einem Substrat unterzubringen. Diese Anordnung von Halbleiterchips auf einem Substrat kann als eine Einheit in verschiedenen Geräten eingefügt werden.

Bei einer Technologie nach dem Stand der Technik verlangte jeder Modul, der eine andere Kombination von Chips aufwies, ein speziell für diese Kombination von Halbleiterchips entworfenes Substrat. Selbst bei einem Modul mit nur einem Halbleiterchip erforderte jedes andere Chip ein anderes Substrat, das für das betreffende Halbleiterchip einmalig ist. Beispiele für die Technologie nach dem Stand der Technik zur Lieferung eines Substrates für ein bestimmtes Halbleiterchip oder eine spezielle Kombination von Halbleiterchips sind in den U. S. Patenten 4 202 007 und 4 193 082 dargestellt, in denen eine Technologie zur Herstellung von Substraten mit vergrabener Verdrahtung beschrieben ist sowie im IBM Technical Disclosure Bulletin, Vol. 22, No. 5 vom Oktober 1979 auf den Seiten 1841-1842, auf denen eine andere Technologie beschrieben ist. Dieser Stand der Technik zeigt jedoch nur eine Technik zur Bildung von Substraten, die vorgegebene Halbleiterchips oder Kombinationen davon aufnehmen. Die Notwendigkeit, für jedes Halbleiterchip und jede andersartige Kombination von Halbleiterchips ein anderes Substrat zu entwerfen, herzustellen und auf Lager zu halten, verteuert die Produkte und geht merklich in die Kosten ein.

Hier will die Erfindung Abhilfe schaffen. Die Erfindung, wie sie in den Ansprüchen gekennzeichnet ist, löst die Aufgabe, ein Substrat für Halbleiterchips zu schaffen, das zur Aufnahme unterschiedlicher Halbleiterchips geeignet ist und das durch eine Oberflächenmetallisierung leicht für eine bestimmte Anwendung personalisiert werden kann. Dadurch wird eine merkliche Kostensenkung der Substrate ermöglicht.

Im folgenden wird die Erfindung in Verbindung mit den Zeichnungen näher erläutert. Es zeigt

Figur 1 eine Draufsicht auf eine Anordnung nach der Erfindung für das Packen von Halbleiterchips, die das Substrat und die darauf befestigten Halbleiterchips zeigt ;

Figur 2 die Ansicht eines Schnittes, der im wesentlichen längs der durch die Linie 2-2 der Figur 1 bezeichneten Ebene geführt wurde ;

Figur 3 die Ansicht eines Schnittes, der im wesentlichen längs der durch die Linie 3-3 der Figur 1 bezeichneten Ebene geführt wurde ;

Figur 4 die Ansicht eines Schnittes, der im wesentlichen längs der durch die Linie 4-4 der Figur 1 bezeichneten Ebene geführt wurde und

Figur 5 eine perspektivische auseinandergezogene Darstellung einiger Schichten, die zur Bildung des Substrates nach Figur 1 benutzt werden.

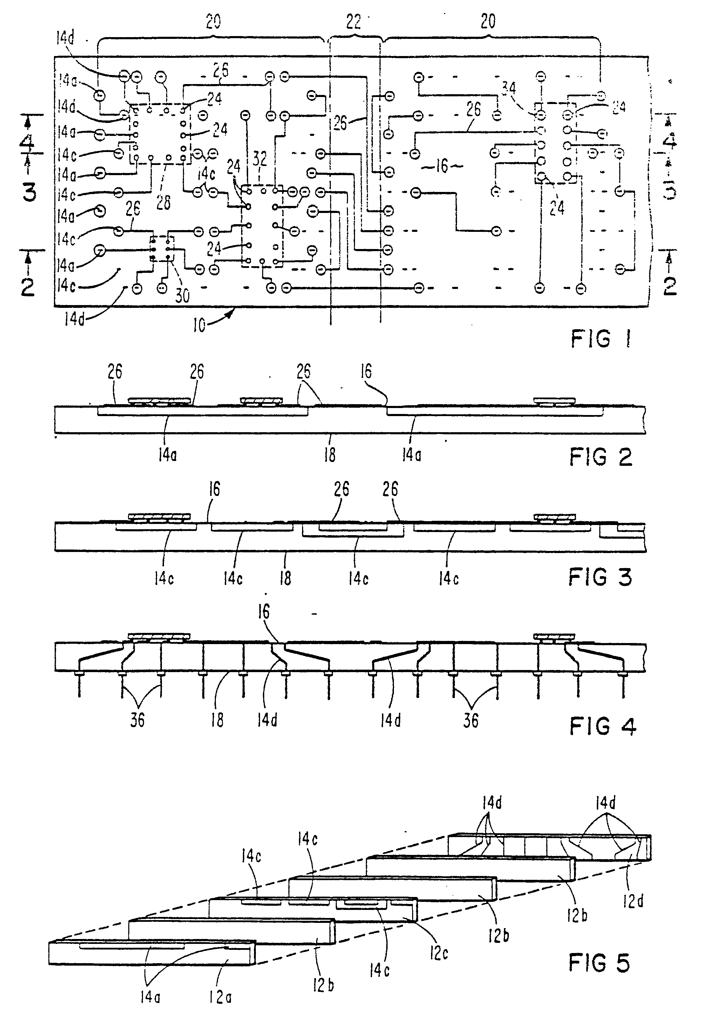

In Figur 1 ist ein Substrat dargestellt, das zwei sich wiederholende Muster von Oberflächenabschlüssen der Leiterzüge aufweist. Es sei bemerkt, daß das Substrat länger gemacht werden könnte mit zusätzlichen sich wiederholenden Mustern, aber für die Zwecke der Erläuterung sind zwei gezeigt.

Das Substrat, das mit der Bezugszahl 10 bezeichnet ist, wird gebildet aus einer Reihe von verschiedenen streifenförmigen Lamellen 12a, 12b, 12c und 12d, von denen einige in Figur 5 dargestellt sind. Die Lamellen sind dünne Blätter von grünem (ungehärtetem) keramischen oder anderen dielektrischen Material. Verschiedene Lamellen 12a, 12c und 12d weisen auf ihren Stirnflächen elektrische Leiterzüge 14a, 14c und 14d auf. Die Leiterzüge 14a und 14c befinden sich in einem Muster, das an der oberen Kante der Lamelle beginnt, sich längs der Stirnseite unter die Deckfläche erstreckt und wieder zu ihr zurückkehrt. Die Leiterzüge 14d erstrecken sich von der Deckfläche der Lamelle längs der Stirnseite zu der Grundfläche. Einige der Lamellen, die durch die Schicht 12b dargestellt werden, können keine Leiterzüge aufweisen und dienen dazu, den seitlichen Abstand der Enden der Leiterzüge zu beeinflussen.

Die erforderliche Anzahl von Lamellen, sowohl mit Leiterzügen als auch ohne, wird in der Weise zusammengefaßt, daß die Stirnseiten mit den Leiterzügen in der gleichen Richtung orientiert werden, um das Substrat 10 zu bilden, wobei die Deckflächen die Fläche 16 zur Aufnahme eines Halbleiterchip bilden und die Grundflächen die Unterseite 18. Die zusammengefaßten keramischen Lamellen werden in üblicher Weise gebrannt, um eine einheitliche Struktur zu bilden. Das Verfahren zur Bildung der Schichten und des Substrates aus ihnen ist bekannt und in den bereits erwähnten U. S. Patenten 4 202 007 und 4 193 082 beschrieben.

Wie aus der Zeichnung ersichtlich, weist das fertiggestellte Substrat auf seiner oberen Fläche zwei Muster von Leiterzugsenden 20 auf, die durch eine Fläche oder einen Streifen 22 getrennt sind, der frei von Leiterzugsenden ist. In der Zeichnung sind die Enden der Leiterzüge auf der Fläche zur Aufnahme der Halbleiterchips als Striche (—) dargestellt, die grob ihre Form annähern. Wenn die Oberflächenmetallisierung mit den Leiterzugsenden verbunden wird, wie das weiter unten beschrieben wird, ist diese Verbindung durch einen Kreis um den Strich dargestellt. Die betreffenden Leiterzüge sind in Figur 1 mit den Bezugszahlen 14a, 14c und 14d auf der linken Seite bezeichnet. Jeder Strich auf der gleichen horizontalen Linie befindet sich auf der gleichen Lamelle. Das Verbindungsmuster kann aus den Figuren 2, 3 und 4 bestimmt werden. Mit dieser Technik können abwechselnd Leiterzugsmuster und von Leiterzugsenden freie Bereiche viele Male wiederholt werden.

Der Abstand der Leiterzugsenden in jedem der Leiterzugsmuster 20 ist so festgesetzt, daß innerhalb der Leiterzugsmuster Platz für die Stellen zur Aufnahme der Halbleiterchips vorgesehen ist. Auf diesen Stellen können metallische Anschlußflächen 24 zur Befestigung der Halbleiterchips untergebracht werden. Diese Anschlußflecken sind auch für die Verbindung mit der Oberflächenmetallisierung oder Verdrahtung 26 geeignet. (Diese Anordnung kann auch benutzt werden für das Verbinden mittels Drähten oder anderen Arten der Verbindung mit dem Halbleiterchip.) Die Anschlußflecken 24 können innerhalb der für das Halbleiterchip vorgesehenen Stelle so angeordnet sein, daß ausgewählte Halbleiterchips aufgenommen werden, die auf dem Substrat zu befestigen sind und mit ihm durch übliche Lötverbindungstechniken verbunden werden. Es ist ersichtlich, daß viele verschiedene Konfigurationen der Anschlußflecken 24 für das Befestigen der Halbleiterchips oder der Verdrahtungsmetallisierung für jedes der Muster angewandt werden können, um sich der erforderlichen Auswahl der Mischung von Halbleiterchips anzupassen, die auf dem Substrat zu benutzen ist. Dieses ermöglicht dann die Personalisierung eines einzelnen Substrates, um sich einer großen Vielfalt und Mischung von Halbleiterchips anzupassen. Vier Halbleiterchips 28, 30, 32 und 34 sind in zwei benachbarten Mustern dargestellt.

Eine Kombination der unter der Oberfläche verlaufenden Leiterzüge 14a, 14c, 14d und der Verdrahtung 26 auf der Fläche zur Befestigung der Halbleiterchips verbinden die verschiedenen Halbleiterchips 28, 30, 32 und 34 miteinander und mit Eingangs-/Ausgangsstiften 36, die an der Unterseite 18 des Substrates befestigt sind. In einigen Fällen können andere Arten von Eingangs-/Ausgangsverbindungen anstelle der Eingangs-/Ausgangsstifte verwendet werden, wie z. B. Randverbindungen. Wie aus den Figuren 1, 2 und 3 ersichtlich, sorgt die Konfiguration der Leiterzüge 14a und 14c für unter der Oberfläche verlaufende Verbindungen zwischen den verschiedenen Punkten auf der Fläche zur Befestigung des Halbleiterchips. Beispielsweise sorgen die Leiterzüge 14a für eine Verbindung zwischen der äußersten Seite eines Musters und der anderen Seite, während die Leiterzüge 14c für Verbindungen innerhalb jedes Musters sorgen als auch für eine unter der Oberfläche verlaufende Verbindung zwischen einem Muster und dem benachbarten Muster unterhalb des Streifens 22 auf der Fläche zum Befestigen der Halbleiterchips.

Der Streifen 22 auf der Fläche zum Befestigen der Halbleiterchips sorgt für einen verhältnismäßig großen Oberflächenbereich, der frei von Enden der Leiterzüge ist, um einen großen Teil der Oberflächenverdrahtung unterzubringen, die lange orthogonale Segmente erfordern kann und welche Verdrahtung sowohl Leiterzugsenden in dem gleichen Muster als auch Leiterzugsenden von einem Leiterzugsmuster jenseits des Streifens 22 mit den Leiterzugsenden in dem nächsten Leiterzugsmuster verbindet.

Daher kann durch Verwendung sich wiederholender Muster von Leiterzugsenden auf der Oberfläche, die durch unterhalb der Oberfläche verlaufende Leiterzüge miteinander verbunden sind und Zwischenräume zwischen den sich wiederholenden Mustern für die Verdrahtung aufweisen, die lange orthogonale Segmente besitzt, ein Substrat für viele Kombinationen von Halbleiterchips verwendet werden.

Es sei bemerkt, daß die Figuren in verschiedener Hinsicht gegenüber üblichen, tatsächlichen praktischen Ausführungsbeispielen in verschiedener Hinsicht aus Gründen der Klarheit vereinfacht wurden. Die Modifikationen schließen ein, daß nur wenige Lamellen dargestellt wurden, die ein Substrat bilden, wogegen viel mehr verwendet werden könnten, um für eine dichtere Verbindung und/oder ein größeres Substrat zu sorgen. Ebenso wurde nur eine ausgewählte Probe von Oberflächenverbindungen und Verdrahtung gezeigt, und diese Verdrahtung könnte viel dichter sein. Auch würden die meisten Halbleiterchips mehr Lötverbindungspunkte aufweisen als die dargestellten. Jedoch wurde aus Gründen der Klarheit nur wenige dieser verschiedenen Elemente zur Erläuterung der Erfindung dargestellt.

Das oben beschriebene Verfahren der Bildung eines Substrates aus Lamellen unter Verwendung von deren Deckflächen, um eine Fläche zur Befestigung der Halbleiterchips zu bilden, ist die bevorzugte Technologie. Jedoch könnte auch die Technologie benutzt werden, die Schichten verwendet, die so zusammengefügt sind, wie das in dem genannten IBM Technical Disclosure Bulletin, Vol. 22, No. 5, Oktober 1979 auf den Seiten 1841-1842 dargestellt ist.

## Patentansprüche

1. Substrat für Halbleiterchips, bei dem
    a) in seinem Inneren zwei Gruppen von Leiterzügen (14a, 14c ; 14d) verlaufen,
    b) die Leiterzüge (14a, 14c) der ersten Gruppe wieder auf der oberen Fläche des Substrates (10) beginnen und enden,

c) die Leiterzüge (14d) der zweiten Gruppe sich von der oberen zur unteren Fläche des Substrates erstrecken und an Verbindungsstifte (36) führen,

d) die Leiterzugsenden in sich in Längsrichtung des Substrates wiederholenden Mustern (20) angeordnet sind, die durch von Leiterzugsenden freie Bereiche (22) der oberen Substratfläche getrennt sind,

e) ein Teil der Leiterzüge (14c) der ersten Gruppe innerhalb eines Musters von Leiterzugsenden verläuft, dadurch gekennzeichnet, daß

f) ein anderer Teil der Leiterzüge der ersten Gruppe der Verbindung mit benachbarten Mustern dient,

g) ein Teil der Leiterzugsenden über eine Oberflächenmetallisierung (26) mit Anschlußflecken (24) für Halbleiterchips, ein anderer Teil mit Leiterzugsenden eines benachbarten Musters verbunden ist und daß

h) von einem Muster von Leiterzugsenden mehrere unterschiedliche Halbleiterchips aufnehmbar und mit anderen Halbleiterchips im gleichen oder in benachbarten Mustern verbindbar sind.

2. Substrat nach Anspruch 1, dadurch gekennzeichnet, daß es aus einer Vielzahl von streifenförmigen Lamellen (12) zusammengesetzt ist, die auf ihrer Vorderseite die Leiterzüge tragen und deren Grundflächen die untere und deren Deckflächen die obere Fläche des Substrates bilden.

3. Substrat nach Anspruch 2, dadurch gekennzeichnet, daß die auf der Vorderseite der streifenförmigen Lamellen aufgebrachten Leiterzüge an der vorderen oberen Kante beginnen und enden bzw. von dort zur unteren Kante verlaufen.

**Claims**

1. Substrate for semiconductor chips, with

a) two groups of conductors (14a, 14c ; 14d) being provided internally

b) the conductors (14a, 14c) of the first group beginning and ending on the surface of the substrate (10)

c) the conductors (14d) of the second group extending from the upper to the lower surface of the substrate and leading to connector pins (36)

d) the conductor ends being arranged in patterns (20) repeated in the longitudinal direction of the substrate, said patterns being separated by strips (22) without conductor ends of the upper substrate surface

e) part of the conductors (14c) of the first group extending within a pattern of conductor ends,

characterized in that

f) another part of the conductors of the first group serves for the connection of the adjacent patterns

g) part of the conductor ends are connected via a surface metallization (26) to pads (24) for semiconductor chips, and another part to conductor ends of an adjacent pattern, and that

h) a pattern of conductot ends can receive a plurality of different semiconductor chips and connect them to other semiconductor chips in the same pattern or in adjacent patterns.

2. Substrate as claimed in claim 1, characterized in that it consists of a plurality of strip-shaped laminae (12) which on their front side show the conductors and which with their bases form the lower, and with their upper faces the top of the substrate.

3. Substrate as claimed in claim 2, characterized in that the conductors provided on the front side of the strip-shaped laminae begin and end at the upper front edge and extend from there to the lower edge.

**Revendications**

1. Substrat pour puces semiconductrices, dans lequel

a) deux groupes de bandes conductrices (14a, 14c ; 14d) s'étendent à l'intérieur du substrat (10),

b) les bandes conductrices (14a, 14c) du premier groupe commencent et se terminent à nouveau à la surface supérieure du substrat (10),

c) les bandes conductrices (14d) du deuxième groupe s'étendent de la surface supérieure à la surface inférieure du substrat et conduisent à des broches de jonction (36),

d) les extrémités des bandes conductrices sont disposées en dessins (20) qui se répètent dans la direction longitudinale du substrat et sont séparés par des zones (22) de la surface supérieure du substrat exemptes d'extrémités de bandes conductrices,

e) une partie des bandes conductrices (14c) du premier groupe 20 s'étend à l'intérieur d'un dessin d'extrémités de bandes conductrices, caractérisé en ce que

f) une autre partie des bandes conductrices du premier groupe sert à la liaison avec des dessins voisins,

g) une partie des extrémités de bandes conductrices est reliée par une métallisation de surface (26) avec des points de raccordement (24) pour puces semiconductrices, une autre partie avec des extrémités de bandes conductrices d'un dessin voisin et en ce que

h) un dessin d'extrémités de bandes conductrices peut accueillir plusieurs puces semiconductrices différentes qui peuvent être reliées avec d'autres puces semiconductrices dans le même dessin ou dans des dessins voisins.

2. Substrat selon la revendication 1, caractérisé en ce qu'il est composé d'une pluralité de lamelles (12) en forme de rubans qui portent sur leur face avant les bandes conductrices et dont les faces de dessous et de dessus constituent respectivement la surface inférieure et la surface supérieure du substrat.

3. Substrat selon la revendication 2. caractérisé en ce que les bandes conductrices placées sur la face avant des lamelles en forme de rubans commencent et se terminent à l'arête avant supérieure ou s'étendent de là à l'arête inférieure.

FIG 1

FIG 2

FIG 3

FIG 4

FIG 5